# EUROPEAN PATENT APPLICATION

(11) **EP 3 450 110 A1**
(43) Date of publication of application: **06.03.2019**
(21) Application number: 17188716.9
(22) Date of filing: 31.08.2017
(51) Int. Cl.: B25F 5/00, B25B 21/00, H03K 17/18, B25B 23/147

(54) **TORQUE TOOL LEVER POSITION DETECTION ARRANGEMENT**

(71) Applicant: Jan OSSA trading as ZBM OSSA, 43-100 Tychy (PL); Akademia Gorniczo-Hutnicza im. Stanislawa Staszica w Krakowie, 30-059 Krakow (PL)
(72) Inventor: OSSA, Jan, 44-251 Rybnik (PL); ZAWADA, Lukasz, 43-100 Tychy (PL); PIATEK, Pawel, 31-221 Kraków (PL); PILAT, Adam, 31-234 Kraków (PL); PAULUK, Mariusz, 32-400 Myslenice (PL); BARANOWSKI, Jerzy, 32-010 Luborzyca (PL); DZIWINSKI, Tomasz, 44-217 Rybnik (PL)
(74) Representative: Malcherek, Piotr

(57) **Abstract**

The invention is related to a position sensing detector (8) of a gear lever (7) of a torque tool (1) which is provided for tightening and loosening screw connections with adjustable torque. The detector (8) comprises a transformer (9), the primary winding (9A) of which is placed in the body of a motor (2) of the torque tool (1), while the secondary winding (9B) is placed in the body of a gearbox (4). The gearbox (4) is fixed to the motor (2) in a way that ensures mutual rotation of their bodies by any angle. The primary winding (9A) is connected with an electronic excitation system (10) of periodically variable voltage and with an electronic measuring system (11), while the secondary winding (9B) is connected parallelly to a capacitor (12) and an electrical contact (13) connected with the gear lever (7). The electronic measuring system (11) of the primary winding (9A) is connected with a comparator circuit (14), configuration of which allows, on the basis of the set current values (W) and the ongoing measurement of the current from the measuring system (11), to send a signal (T) on the status of the position of the gear lever (7) to the control unit (3) of the motor (2) in the torque tool (1).

## Description

### Subject of the invention

The subject of the invention is a position sensing detector of a gear lever of a gearbox of an electric torque tool, particularly a digitally controlled high-torque electric tool in which a two-gear gearbox is fixed to a motor with ensured mutual rotation of their bodies by any angle.

### Background art

Electric torque tools, including high-torque electric tools, are used to tighten and loosen screw connections with an adjustable and controllable torque. In general, such a torque tool includes an electric motor controlled by a control unit and a gearbox integrated with a reduction gear. Thanks to the shift of gear, the torque tool can work in a wider range of torques. What is more, in order to increase the utility values of the torque tool and improve the operator's working comfort, the gearbox is fixed to the motor in a way that ensures mutual rotation of their bodies by any angle. Shift of gears of such a torque tool is executed with a mechanical lever. The operator uses the setter to input the set torque of the tightening process. The setter has positions, for example from position 1 to position 99, in which the setting reflects a specific value of the torque. The position of the gear lever is of importance, as its shifting changes the working range of the torque tool with regard to torques. In practice, there are events in which the operators make mistakes concerning the choice of the desired setting with an incorrect position of the gear lever. Such mistakes lead to operation of the torque tool with torque that is different from the intended one. In the case of known and currently applied torques of torque tools, it is sufficient to have a gearbox with two working gears. That is why manual two-position levers are commonly used.

The state of the art also includes torque tools equipped with an automatic gear switch. The operator also sets the desired torque with a setter. In the case of such a construction, the shift of gears takes place automatically when the proper torque is reached. An inconvenience of such a construction is a smaller range of available torques and inaccurate operation of the torque tool for torques close to the threshold of the automatic gear shifting.

### Aim of the invention

The main aim of the invention is to develop a construction of a detector integrated with a torque tool that would provide the possibility of automatic detection of the working gear and, at the same time, ensure the full rotation of the gearbox body against the body of the motor. By the full rotation of the gearbox body against the body of the motor, one shall understand such a construction that provides its mutual rotation against the axis of the motor shaft by any angle within the range from 0° to 360° or its multiple, which means that these bodies may mutually rotate against each other multiple times.

### Essence of the invention

The essence of the invention is that the detector is equipped with a transformer, the primary winding of which is seated in the body of the motor of the torque tool, while the secondary winding is seated in the body of the gearbox. The primary winding is connected with an electronic excitation system that generates periodically variable voltage and with an electronic measuring system, while the secondary winding is connected parallelly to a capacitor and an electrical contact connected to the gear lever. Moreover, the electronic measuring system of the primary winding is connected with a current comparator circuit, the configuration of which allows, on the basis of the set current values and the current measurement of the current from the measuring system, to send a signal on the status of the position of the gear lever to the control unit of the motor in the torque tool.

It is advantageous when the primary winding of the transformer, the secondary winding of the transformer, and the capacitor on the side of the secondary winding form a circuit with resonant properties. The circuit works in resonance due to the fact that the excitation system provides voltage with a specific frequency, in particular resonant frequency, which is dependent on the parameters of the resonance circuit, including the resultant inductance of the primary and secondary windings and the capacity of the capacitor.

### Advantageous effects of the invention

Application of a position sensing detector of the gear lever of the gearbox in the construction of the torque tool excludes the risk of tightening a screw with an insufficient or excessive torque. When implementing a setting of the desired torque, the operator inputs the value of the chosen torque in the setter. The detector indicates the current position of the mechanical gear lever. Simultaneously having a set torque and the position of the gear lever obtained from the detector, the controller automatically checks whether it is possible to perform the work with the set torque in that particular position and, in the case of lack of possibility to work with the set torque, signals the necessity of changing in the position of the gear lever. In particular, the position of the mechanical gear lever is transformed into an electrical signal and then conveyed in a wireless and a contact-free manner through a mechanical rotary joint fixing the electric motor. Such conveying of the signal is possible thanks to the application of the transformer, the primary and secondary parts of which are located in adjacent parts of the torque tool that are rotatable against each other. The rotary joint can rotate freely around the axis designated by the motor shaft. Conveying of information in a wireless and contact-free manner takes place with the use of two parts of the transformer and accompanying electronic systems connected with relevant parts of the transformer. Thus, the construction of the detection system is designed in a way in which the power supply must be provided only to the part of the system located on the side of the motor. The second part of the circuit, located on the side of the gearbox and the reduction gear, does not require such a power supply, which allows providing free rotation of both adjacent bodies of the motor and the gearbox of the torque tool. Consequently, the operator does not have to calculate the position of the controller and control the position of the gear lever.

### Description of the drawings and embodiments

The invention has been further presented in the accompanying drawings, in which:
Fig. 1 illustrates the plan of the torque tool by individual main components;
Fig. 2 - a general flowchart of the detector;
Fig. 3 - a detailed flowchart of the detector.

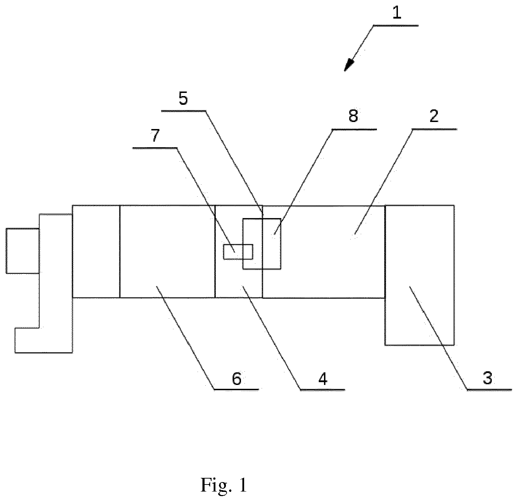

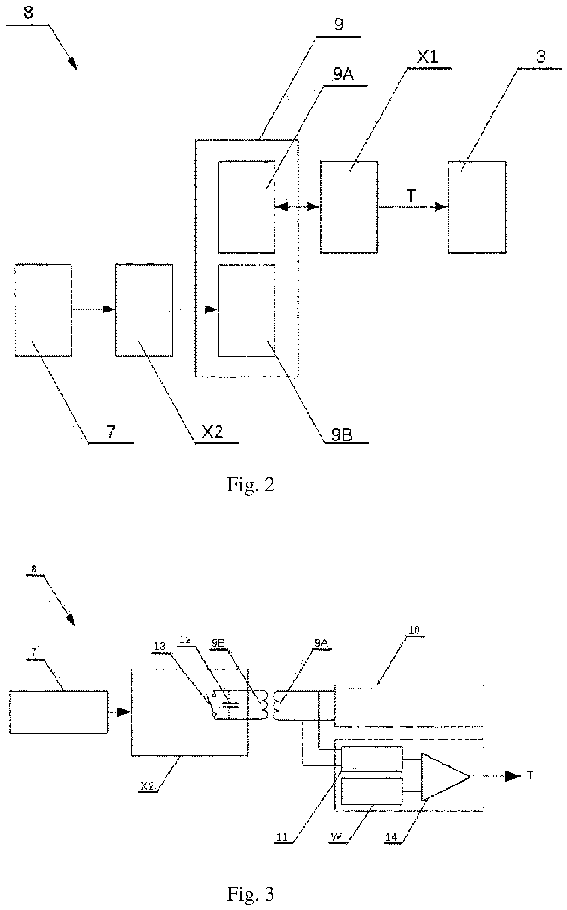

The electric torque tool 1 (fig.1) is provided for tightening and loosening of screws with adjustable torque and it is equipped with a motor 2 with a control unit that has a digital controller 3. The motor 2 is connected with a gearbox 4 through a mechanical rotary joint 5. In particular the rotary joint 5 provides a full rotation of the body of the gearbox 4 against the body of the motor 2. Full rotation is understood as a construction that allows their mutual rotation against the shaft of the motor 2 by any selected angle within the range from 0° to 360° or its multiple. In turn, the gearbox 4 is integrated with a reduction gear 6. A shift of gears of the gearbox is performed with the use of a manual two-position lever 7. The control system of torque tool 1 is connected with a position sensing detector 8 of the gear lever 7 of the gearbox 4. The detector 8 includes a transformer 9, whose primary winding 9A is seated in the body of the motor 2, while a secondary winding 9B is placed in the body of the gearbox 4, and the axial positions thereof correspond with each other. The primary winding 9A is connected with an electronic excitation system 10 of periodically variable voltage and with an electronic measuring system 11. In turn, the secondary winding 9B is connected parallelly to a capacitor 12 and to an electrical contact 13, which are connected with the gear lever 7. Moreover, the electronic measuring system 11 of the primary winding 9A is connected with a comparator circuit 14, the configuration of which allows, on the basis of the set current values, in particular the reference value W and the ongoing measurement of the current from the measuring system 11, to send signal T on the position status of the gear lever 7 to the digital controller 3 of the motor 2. The electronic excitation system 10 of periodically variable voltage, the electronic measuring system 11 and the current comparator circuit 14 form an electronic system X1 of the primary side of the transformer 9, while the capacitor 12 and the electrical contact 13 form an electronic system X2 of the secondary side of the transformer 9 (fig. 2).

Fig.3 illustrates in detail that the winding of the transformer 9 on the side of the motor 2, in particular the primary winding 9A is connected to the electronic excitation system 10 and the electronic measuring system 11. The excitation system 10 generates an electrical signal with a sinusoidal flow or a flow that is close to sinusoidal. Connecting such a flow to the primary winding 9A of the transformer 9 results in a current flow with a value that depends on impedance of that primary winding 9A. Such impedance depends on the value of mutual inductance of both windings 9A and 9B of the transformer 9. The winding of the transformer 9 on the side of the gearbox 4, in particular the secondary winding 9B, is connected parallelly to the capacitor 12 and the electrical contact 13. The electrical contact is understood also as an electrical switch or a reed switch that is able to short the secondary winding 9B. In the first position of the lever 7, the secondary winding 9B with the capacitor 12 is shorted with the contact 13 and, in the second position of the lever 7 it is not shorted. In particular, a change in position of the gear lever 7 results in a shift of the magnet and shorting of contact, and, therefore, of the circuit of the secondary winding 9B and the capacitor 12. Such shorting results in a change of the mutual inductance of the transformer 9 and, therefore, in a change of the value of the current flowing through the primary winding 9A on the side of the motor 2. The electronic measuring system 11 is used for constant measurement of the current flowing within the circuit of the primary winding 9A of the transformer 9. In the circuit of the comparator 14, that value is compared with the threshold value, in particular the reference value W, determined during assembly of the torque tool 1. After a change is identified, the status is signaled through a change of the output state of the circuit. The output of the circuit may reach a status of logic 0 and logical 1, which are then respectively identified by the digital controller 3 and, in the case in which it is impossible to work with the desired torque, the need to change the position of the gear lever 7 is signaled. It is significant here that no application of additional power supply is required on the side of the manual lever.

The primary winding 9A, the secondary winding 9B, and the capacitor 12 on the side of the secondary winding 9B form an advantageous circuit with resonant properties, hereinafter referred to as resonance circuit. Provision of voltage by the excitation system 10 with a specific frequency, in particular resonant frequency, dependent on parameters of the resonance circuit, including resultant inductance of the primary and secondary windings and the capacity of the capacitor makes the circuit work in resonance, in which it amplifies the signal from the excitation system 10. Thanks to that the conditions for detecting the position of the lever 7 are improved. Shorting of the capacitor 12 on the side of the secondary winding 9B causes a change in parameters of the resonance circuit, which leads to a change of value of the current that flows in the primary winding 9A. The measuring circuit 14 may distinguish two different states of impedance of the primary coil 9A and convey a relevant signal to the digital controller 3.

List of reference numbers in the drawing:
1 - electric torque tool
2 - motor
3 - digital control unit
4 - gearbox
5 - rotary joint
6 - reduction gear
7 - lever
8 - detector
9 - transformer
9A - primary winding of the transformer
9B - secondary winding of the transformer
10 - electronic excitation system
11 - electronic measuring system
12 - capacitor
13 - electrical contact
14 - comparator circuit
T - signal to the controller
W - reference value
X1 - electronic system of the primary side of the transformer
X2 - electronic system of the secondary side of the transformer

## Claims

1. Position sensing detector (8) of a gear lever (7) of a torque tool (1) which is provided for tightening and loosening of screw connections with an adjustable torque, which torque tool comprises an electric motor (2) controlled through a control unit (3), where the motor (2) is integrated with a gearbox (4), whereby the gearbox (4) is fixed to the motor (2) so that mutual rotation is provided for their bodies by any angle, and a shift of gear is implemented with the use of the said mechanical two-position lever (7), **characterized in that** it comprises a transformer (9), the primary winding (9A) of which is seated in the body of the motor (2), while the secondary winding (9B) is seated in the body of the gearbox (4), whereby the primary winding (9A) is connected with an electronic excitation system (10) of periodically variable voltage and with an electronic measuring system (11), while the secondary winding (9B) is parallelly connected to a capacitor (12) and an electrical contact (13) integrated with the gear lever (7), while the electronic measuring system (11) of the primary winding (9A) is connected with a comparator circuit (14) which is configured to send a signal (T) concerning the position status of the gear lever (7) to the digital control unit (3) of the motor (2) of the torque tool (1) on the basis of set values of the current (W) and the ongoing measurement of the current from the measuring system (11).

2. The detector according to claim 1, **characterized in that** the primary winding (9A) and the secondary winding (9B) of the transformer (9) and the capacitor (12) are configured to form a circuit with resonant properties, while the electronic excitation system (10) is configured to generate a periodically variable signal with a frequency equal to the resonance frequency of the circuit with resonant properties.
